**Europäisches Patentamt**

**European Patent Office**

**Office européen des brevets**

(19)

(11) Veröffentlichungsnummer: **0 195 350 B1**

---

(12) **EUROPÄISCHE PATENTSCHRIFT**

(45) Veröffentlichungstag der Patentschrift: **11.12.91**

(51) Int. Cl.⁵: **C04B 41/00**, C04B 35/54, C30B 15/10

(21) Anmeldenummer: **86103220.9**

(22) Anmeldetag: **11.03.86**

(54) **Verfahren zur Regenerierung von Formkörpern aus Kohlenstoff.**

(30) Priorität: **13.03.85 DE 3508999**

(43) Veröffentlichungstag der Anmeldung:
**24.09.86 Patentblatt 86/39**

(45) Bekanntmachung des Hinweises auf die
Patenterteilung:
**11.12.91 Patentblatt 91/50**

(84) Benannte Vertragsstaaten:
**DE FR GB IT**

(56) Entgegenhaltungen:
**DE-A- 3 026 049**

(73) Patentinhaber: **Wacker-Chemitronic Gesellschaft für Elektronik-Grundstoffe mbH
Johannes-Hess-Strasse 24
W-8263 Burghausen(DE)**

(72) Erfinder: **Priewasser, Georg
Duttendorf 155
A-5122 Ach(AT)**
Erfinder: **Ellbrunner, Adalbert
Kirchdorfer Strasse 9
W-8265 Seibersdorf(DE)**
Erfinder: **Stock, Horst, Dipl.-Phys.
Fraunhoferstrasse 5
W-8263 Burghausen(DE)**

### Beschreibung

Die Erfindung betrifft ein Verfahren zur Regenerierung von Formkörpern aus Kohlenstoff, insbesondere Graphit, welche in Gegenwart von elementarem schmelzflüssigem Silicium eingesetzt werden, bei dem nach dem Einsatz die zu regenerierenden Formkörper in einer gegenüber Kohlenstoff, insbesondere Graphit inerten Atmosphäre oder Vakuum auf eine Temperatur von 1700 bis 3000° C gebracht und für einen Zeitraum in diesem Temperaturbereich gehalten werden.

Bei Hochtemperaturprozessen in der Technik hat sich Kohlenstoff, insbesondere Graphit, als Werkstoff mit ausgezeichneten Eigenschaften erwiesen. Auch bei den im Rahmen der Herstellung von hochreinem elementarem Silicium als Grundmaterial für elektronische Bauelemente, Solarzellen, oder mikromechanische Bauteile durchgeführten Hochtemperaturschritten wird in den meisten Fallen Kohlenstoff, insbesondere Graphit, eingesetzt, obwohl wegen der bei hohen Temperaturen einsetzenden Bildung von Siliciumcarbid ein direkter Kontakt zwischen geschmolzenem Silicium und Kohlenstoffformkörpern weitestgehend zu vermeiden ist. Aus diesem Grunde wird z. B. bei Verfahren, bei denen große Menge von geschmolzenem Silicium erforderlich sind, wie etwa beim Tiegelziehen nach Czochralski von Siliciumstäben oder beim Gießen von Siliziumblöcken, die Schmelze in der Regel in Quarztiegeln bereitgestellt, welche außen von Graphittiegeln umgeben sind. Obwohl somit die Graphittiegel nicht in direkten Kontakt mit dem geschmolzenen Silicium kommen, werden sie bei diesen Prozessen doch stark beansprucht und müssen häufig ausgewechselt werden, sei es, weil sie an der Oberfläche verspröden und Risse oder Ausbrüche ausbilden, oder weil sie ihre Wärmeleitfähigkeits- und Strahlungscharakteristik ändern. Da die Tiegel mit ihren oft beträchtlichen Ausmaßen - typisch etwa 400 mm Durchmesser und etwa 300 mm Höhe - meist aus massiven Graphitblöcken gefertigt werden müssen, ist ihre Herstellung teuer und aufwendig. Häufiger Tiegelwechsel bedeutet also eine erhebliche Kostenbelastung.

Aus der DE-A-30 26 049 ist ein Verfahren bekannt, nach dem sich dünnwandige verformte Graphithülsen durch Einspannen in eine Halterung und anschließende Temperaturbehandlung im Vakuumofen bei 1900° C regenerieren lassen.

Aufgabe der Erfindung war es daher, ein Verfahren anzugeben, nach dem sich die Standzeit von Formkörpern aus Kohlenstoff, insbesondere Graphit, welche in Gegenwart von elementarem schmelzflüssigem Silicium eingesetzt werden, erhöhen läßt.

Gelöst wird die Aufgabe durch ein Verfahren, welches dadurch gekennzeichnet ist, daß die Stundenzahl des Zeitraumes dem 0,05- bis 1-fachen Wert der in Millimeter gemessenen Wandstärke der Formkörper entspricht, welche 15 bis 40 mm beträgt.

Die Formkörper können grundsätzlich unmittelbar, aber auch innerhalb einer Aufheizperiode von günstig etwa 2 bis 8 Stunden auf die vorgesehene Endtemperatur im Bereich von 1700 bis 3000° C, vorzugsweise 1900 bis 2200° C, gebracht werden. Dabei erfordert der Temperaturbereich unterhalb 1900° C allerdings verhältnismäßig lange Behandlungszeiten. Diese verkürzen sich zwar mit steigender Temperatur, oberhalb 2200° C verstärken sich aber die Materialverluste durch Absublimieren. Hinzu kommt im plastischen Bereich oberhalb von Ca. 2500° C auch eine Verminderung der Formstabilität. Daneben wird auch der apparative Aufwand umso höher, je höher die zu erzeugenden und aufrechtzuerhaltenen Temperaturen liegen. Arbeitstemperaturen oberhalb 3000° C sind daher grundsätzlich zwar möglich, vom apparativen und energetischen Aufwand her jedoch nicht mehr vertretbar.

Der Zeitbedarf für eine die Standzeit erhöhende Regenerierung wird im wesentlichen durch die Wandstärke der Formkörper bestimmt, und zwar nimmt mit der Wandstärke auch die erforderliche Behandlungszeit zu. Dabei entspricht der in Stunden ausgedrückte Zeitbedarf dem 0,05- bis 1-fachen Zahlenwert der in Millimeter gemessenen Wandstärke. Im bevorzugten Temperaturbereich von 1900 bis 2200° C haben sich beispielsweise für die bei Graphitformkörpern gängigen Wandstärken von 15 bis 40 mm bereits Behandlungszeiten von etwa 2 bis 20 Stunden als ausreichend erwiesen. Allgemein läßt sich der Zeitbedarf für die Regenerierung durch eine Temperatursteigerung herabsetzen. Dann sind jedoch gegebenenfalls nachteilige Auswirkungen, wie erhöhte Sublimationsverluste oder Verminderung der Formstabilität zu berücksichtigen.

Nach beendeteter Hochtemperaturbehandlung wird die Temperatur der Formkörper wieder abgesenkt. Zweckmäßig wird der Kühlvorgang in einer eigenen, z.B. wassergekühlten Kühlstation durchgeführt, wobei gegebenenfalls der Innenraum zusätzlich mit Inertgas, zweckmäßig im Normal- bis Überdruckbereich gekühlt werden kann. Bevorzugt wird eine Endtemperatur gewählt, bei welcher bei Kontakt mit der Außenluft Verluste durch Abbrand ausgeschlossen werden können. In der Regel ist es daher erforderlich, die Formkörper aus Kohlenstoff, insbesondere Graphit, auf 400 bis 500° C abzukühlen, ehe man sie an Luft weiter erkalten lassen kann. Bevorzugt wird der Abkühlprozess sogar bis in den Temperaturbereich von 150 bis 250° C ausgedehnt. Je nach Behandlungstemperatur und Größe des jeweils regenerierten Formkörpers hat sich eine Abkühlzeit von 2 bis 10 Stunden als zweckmäßig erwiesen.

Um Verluste durch Abbrand zu vermeiden, wird die Hochtemperaturbehandlung der Formkörper in gegenüber Kohlenstoff, insbesondere Graphit, inerter Atmosphäre durchgeführt, insbesondere unter Vakuum, vorzugsweise bei $10^{-1}$ bis $10^{-3}$m bar oder unter Schutzgasatmosphäre. Geeignete Schutzgase sind z. B. Edelgase, wie Helium, Neon oder insbesondere Argon. Selbstverständlich können auch Schutzgasgemische eingesetzt werden. Grundsätzlich ist es auch möglich, in Temperaturbereichen, in denen erfahrungsgemäß kein Abbrand der Formkörper eintreten kann, also bis zu etwa 400 bis 500° C, das Aufheizen oder Abkühlen an Luft vorzunehmen.

In der Regel ist es nicht nötig, die Formkörper aus Kohlenstoff, insbesondere Graphit, nach jedem Einsatz zu regenerieren, sondern erst dann, wenn sich eine Verschlechterung der Materialeigenschaften bemerkbar macht. Dies kann sich beispielsweise in einer Veränderung der Wärmeübertragungs- und Strahlungseigenschaften äußern oder in Krustenbildung und Versprödung der Oberfläche. Beispielsweise ist bei Graphittiegeln, die beim Gießen von Siliciumblöcken oder beim Tiegelziehen nach Czochralski von Siliciumstäben eingesetzt werden, zumeist nur nach jedem dritten bis zwölften Einsatz die erfindungsgemäße Behandlung nötig, um die Standzeit entscheidend zu verlängern.

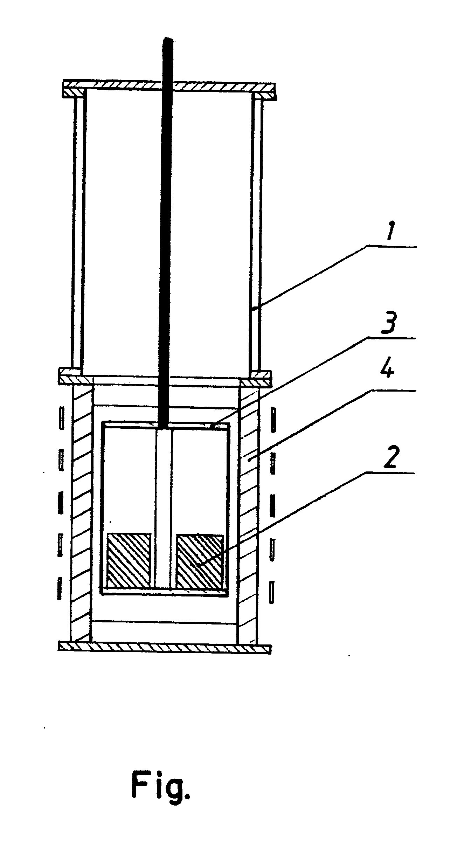

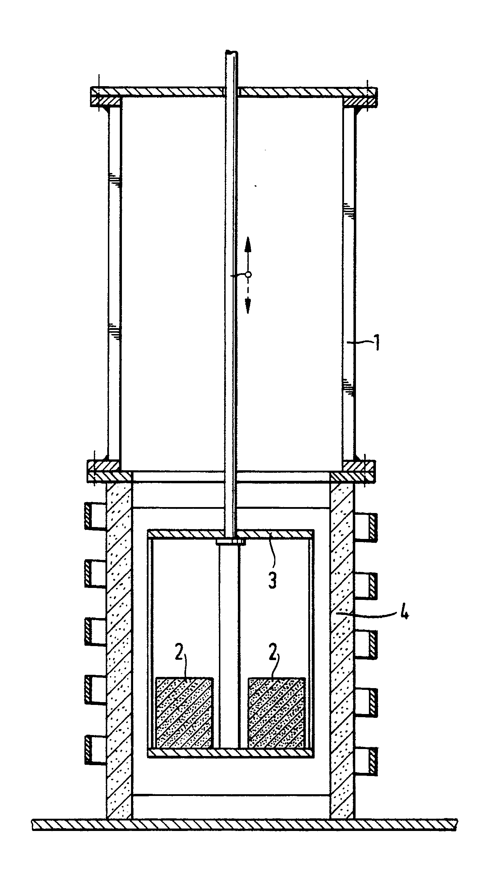

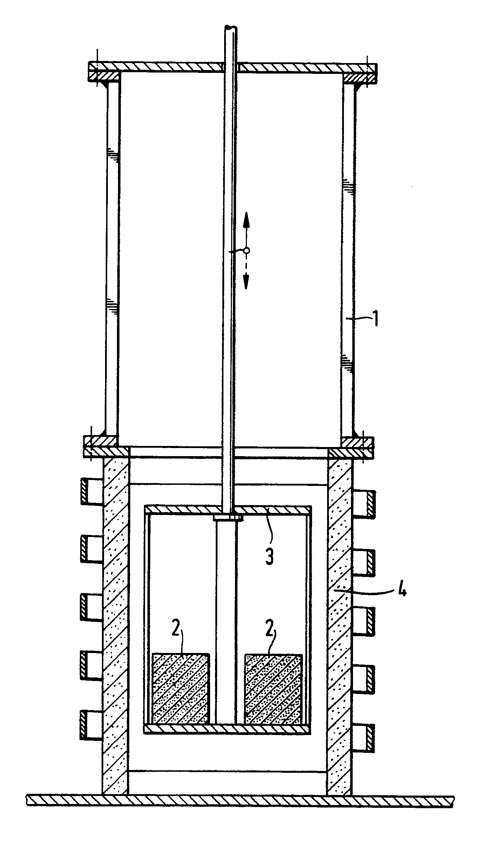

Anhand der Figur wird schematisch eine mögliche Verfahrensweise zur Regenerierung von Formkörpern aus Kohlenstoff, insbesondere Graphit, sowie eine mögliche Vorrichtung zu ihrer Durchführung näher erläutert.

In einer evakuierbaren und z.B. mit Wasser kühlbaren, gleichzeitig auch als Abkühlkammer einsetzbaren Beschickungskammer 1 wird ein mit den auszuheizenden Formkörpern, beispielsweise beim Tiegelziehen von Siliciumstäben nach Czochralski eingesetzten Graphittiegeln 2 beladener Träger 3 bereitgestellt und anschließend in eine, gegebenenfalls vakuumdicht abtrennbare, evakuierbare, gegebenenfalls mit Inertgas spülbare und z.B. induktiv beheizte Heizkammer 4 abgesenkt. Nachdem diese z.B. mittels einer - hier nicht dargestellten - Vakkumpumpe auf einen geeigneten Druck, z.B. $10^{-1}$ bis $10^{-3}$ mbar, gebracht ist, wird die Temperatur innerhalb der vorgesehenen Aufheizzeit auf den ausgewählten Endwert, vorzugsweise im Bereich von 1900 bis 2200° C, erhöht. Nach Ablauf der vorgesehenen Behandlungszeit und gegebenenfalls einer zusätzlichen Abkühlphase wird der Träger 3 wieder in die nunmehr als Abkühlkammer wirkende, evakuierte beziehungsweise mit Inertgas beschickte und intensiv gekühlte Beschickungskammer zurückgefahren und dort belassen, bis die Temperatur soweit abgesenkt ist, daß ohne Abbrandrisko belüftet und die Graphittiegel entnommen werden können.

Selbstverständlich sind auch Anordnungen möglich, bei denen die Entnahme der Formkörper nicht in der Beschickungskammer, sondern in einer eigenen Entnahmekammer vor sich geht.

Auch Anordnungen mit von der Heizkammer abkoppelbaren, vakuumdicht abtrennbaren Beschickungskammern, die zum Einbringen bzw. Entnehmen des Glühgutes an die Heizkammer angekoppelt werden, für den Abkühlvorgang aber von dieser abgenommen werden, sind denkbar. Solche Anordnungen gestatten auch einen Taktbetrieb, bei dem mehrere Beschickungskammern nacheinander zum Einbringen des Glühgutes an die Heizkammer angekoppelt und dann für den Abkühlvorgang abgenommen werden, so daß nunmehr die nächste, mit zu regenerierenden Graphitformkörpern beladene Beschikkungskammer an die Heizkammer angekoppelt werden kann. Eine weitere Möglichkeit besteht darin, die Heizkammer in der Art eines Durchlaufofens zu gestalten, in welchen das zu regenerirende Material aus einer Beschickungskammer eingebracht wird, ehe es nach beendeter Temperaturbehandlung in eine Abkühlkammer weitergeleitet wird.

Die nach dem erfindungsgemäßen Verfahren regenerierten Graphittiegel lassen sich in Gegenwart von schmelzflüssigem Silicium, z. B. bei Tiegelzieh- oder Blockgießverfahren erheblich öfter einsetzen, als nicht regeneriertes Material.

Ausführungsbeispiel:

Eine übliche Apparatur zum Tiegelziehen nach Czochralski von Siliciumstäben (vgl. z. B. W. Zulehner und D. Huber, Czochralski-Grown Silicon, Crystals 8, Springer-Verlag, Berlin-Heidelberg, 1982) war zur Aufnahme der Schmelze (ca. 35 kg Silicium) mit einem Quarztiegel mit Außendurchmesser 350 mm und Höhe 250 mm bestückt, welcher von einem Graphittiegel mit 351 mm Innendurchmesser und 240 mm Höhe bei einer Wandstärke von 20 mm umschlossen war.

Aus dieser Anordnung wurden nach einem üblichen Verfahren (vgl. z.B. W. Zulehner und D. Huber, a.a.O.) Siliciumstäbe (Durchmesser 120 mm, Länge jeweils zwischen 1000 und 1100 mm) gezogen, wobei nach jedem Ziehvorgang der Quarztiegel gewechselt, der Graphittiegel jedoch beibehalten wurde.

Nach jedem zehnten Ziehvorgang wurde der Graphittiegel entnommen und in einer der Figur entsprechenden Apparatur regeneriert.

Zu diesem Zweck wurde der Tiegel in der Beschickungskammer, einem evakuier- und wasserkühlbaren Edelstahlzylinder, auf den Träger aus Graphit aufgelegt und in die Heizkammer gesenkt. Diese bestand aus einem mit Graphitfilz isolierten, vakuumdicht verschließbaren Rohr aus geschmolzenem, undurchsichtigem Quarz, in welchem zur Aufnahme des Heizgutes ein induktiv beheizbares Rohr aus Graphit angeordnet war.

Nun wurde die Heizkammer auf einen Druck von ca. $10^{-2}$ mbar evakuiert und die Temperatur kontinuierlich gesteigert, bis nach etwa 4 Stunden etwa 2050°C erreicht waren. Auf dieser Temperatur wurde der Tiegel nunmehr für ca. 5 Stunden gehalten. Dann wurde die Heizung abgeschaltet und der Tiegel zunächst durch Abstrahlung abkühlen gelassen. Bei etwa 1700°C wurde der Tiegel dann aus der Heizkammer wieder in die inzwischen auf etwa $10^{-2}$ mbar evakuierte und intensiv mit Wasser gekühlte Beschickungskammer hochgefahren. Nach insgesamt etwa 10 Stunden Abkühlzeit hatte der Tiegel eine Temperatur von ca. 200°C erreicht und konnte nach Belüftung der Beschickungskammer entnommen und erneut beim Tiegelziehen eingesetzt werden.

Mit dem solcherart periodisch regenerierten Graphittiegel konnten über 30 Ziehvorgänge durchgeführt werden. Alle erhaltenen Stäbe waren versetzungsfrei und besaßen einen reproduzierbaren Sauerstoff- und Kohlenstoffgehalt.

Vergleichsbeispiel:

In der vorstehend beschriebenen Weise wurde eine weitere Folge von Tiegelziehprozessen durchgeführt, jedoch ohne Regenerierung des eingesetzten Graphittiegels.

Nach 6 Ziehvorgängen begann der Graphittiegel oberflächlich zu verspröden.

Beim zwölften Ziehvorgang waren seine Wärmeleitfähigkeits- und Strahlungseigenschaften bereits so ungleichmäßig, daß der erhaltene Siliciumstab gegenüber den vorhergehenden Stäben erhöhte Kristallstörungen und starke Abweichungen im Kohlenstoff- und Sauerstoffgehalt besaß und daher nicht mehr weiter zu verarbeiten war. Der Graphittiegel zeigte darüberhinaus bereits deutliche Ansätze zur Rißbildung und konnte nicht mehr weiter verwendet werden.

**Patentansprüche**

1. Verfahren zur Regenerierung von Formkörpern aus Kohlenstoff, insbesondere Graphit, welche in Gegenwart von elementarem schmelzflüssigem Silicium eingesetzt werden, bei dem nach dem Einsatz die zu regenerierenden Formkörper in einer gegenüber Kohlenstoff, insbesondere Graphit inerten Atmosphäre oder Vakuum auf eine Temperatur von 1700 bis 3000°C gebracht und für einen Zeitraum in diesem Temperaturbereich gehalten werden, dadurch gekennzeichnet, daß die Stundenzahl des Zeitraumes dem 0,05- bis 1-fachen Wert der in Millimeter gemessenen Wandstärke der Formkörper entspricht, welche 15 bis 40 mm beträgt.

2. Verfahren nach Anspruch 1, **dadurch gekennzeichnet,** daß als inerte Atmosphäre ein Vakuum von $10^{-1}$ bis $10^{-3}$ mbar eingestellt wird.

3. Verfahren nach den Ansprüchen 1 und 2, **dadurch gekennzeichnet,** daß eine Temperatur von 1900 bis 2200°C eingehalten wird.

4. Verfahren nach einem oder mehreren der Ansprüche 1 bis 3, **dadurch gekennzeichnet,** daß im Anschluß an die Temperaturbehandlung die Formkörper vor der Entnahme auf eine Temperatur von weniger als 500°C gekühlt werden.

**Claims**

1. Process for regenerating shaped parts made of carbon, in particular graphite, which are used in the presence of elemental molten silicon, in which process the shaped parts to be regenerated are brought to a temperature of 1700 to 3000°C in an atmosphere which is inert towards carbon, in particular graphite, or in vacuo after use and are held in this temperature range for a period of time, characterised in that the number of hours of the period of time is equal to 0.05 to 1 times the value of the wall thickness of the shaped parts measured in millimetres, which wall thickness is 15 to 40 mm.

2. Process according to Claim 1, characterised in that a vacuum of $10^{-1}$ to $10^{-3}$ mbar is established as inert atmosphere.

3. Process according to Claims 1 and 2, characterised in that a temperature of 1900 to 2200°C is maintained.

4. Process according to one or more of Claims 1 to 3, characterised in that, following the temperature treatment, the shaped parts are cooled before removal to a temperature of less than 500°C.

**Revendications**

1. Procédé pour régénérer des objets moulés ou façonnés en carbone, notamment en graphite, que l'on utilise en présence de silicium élémentaire fondu liquide, procédé dans lequel, après leur emploi, les objets à régénérer sont portés à une température de 1700 à 3000°C, sous vide ou dans une atmosphère inerte à l'égard du carbone, en particulier à l'égard du graphite, température à laquelle ils sont maintenus pendant un certain temps, procécé caractérisé en ce que ce temps de maintien en heures correspond à 0,05 à 1 fois l'épaiseur de paroi de l'objet en milimètres, épaisseur qui est de 15 à 40 mm.

2. Procédé selon la revendication 1, caractérisé en ce que l'on opère dans un vide de $10^{-1}$ à $10^{-3}$ mbar.

3. Procédé selon les revendications 1 et 2, caractérisé en ce que l'on maintient une température de 1900 à 2200°C

4. Procédé selon une ou plusieurs des revendications 1 à 3, caractérisé en ce que, après leur traitement à chaud, les objets sont refroidis à moins de 500°C avant d'être retirés de l'appareil de traitement.

Fig.